# EUROPEAN PATENT APPLICATION

(11) **EP 2 584 611 A1**
(43) Date of publication of application: **24.04.2013**
(21) Application number: 11798046.6
(22) Date of filing: 16.06.2011
(51) Int. Cl.: H01L 31/04

(54) **SILICON WAFER, SEMICONDUCTOR DEVICE, SILICON WAFER PRODUCTION METHOD AND SEMICONDUCTOR DEVICE PRODUCTION METHOD**

(30) Priority: 21.06.2010 JP 2010140655
(71) Applicant: Sharp Kabushiki Kaisha, Osaka-shi, Osaka 545-8522 (JP)
(72) Inventor: TAKAKI, Akihide, Osaka-shi Osaka 545-8522 (JP); NAKAMURA, Masatsugu, Osaka-shi Osaka 545-8522 (JP); NISHINO, Mitsutoshi, Osaka-shi Osaka 545-8522 (JP); OHTAKE, Yasutoshi, Osaka-shi Osaka 545-8522 (JP)
(74) Representative: Müller - Hoffmann & Partner
(86) International application number: PCT/JP2011/063818
(87) International publication number: WO 2011/162161

(57) **Abstract**

A silicon wafer (1) obtained by etching by not less than 5 µm and not more than 25 µm per surface on either side a surface of crystalline silicon (11) obtained by cutting a silicon crystal ingot (50), the silicon wafer (1) having a surface with a facet (62) having a width of not less than 10 µm and not more than 150 µm, and a semiconductor device having an electrode (12, 13) at that surface, are provided. Furthermore, a method for producing the silicon wafer (1) and a method for producing the semiconductor device that include the step of etching a surface of the crystalline silicon (11) with an aqueous solution of sodium hydroxide having a sodium hydroxide concentration of not less than 20% by mass and not more than 35% by mass by not less than 5 µm and not more than 25 µm per surface on either side, are also provided.

## Description

### TECHNICAL FIELD

The present invention relates to a silicon wafer, a semiconductor device, a method for producing the silicon wafer, and a method for producing the semiconductor device.

### BACKGROUND ART

Development of clean energy has recently been desired in view of the problem of exhaustion of energy resources and the global environment problem such as an increase in CO₂ in the air, and photovoltaic power generation employing semiconductor devices, in particular solar cells has been developed and put into practice as a new energy source, and is now on the way to progress.

A conventional mainstream solar cell is a bifacial solar cell which is produced, for example, by diffusing, into a light receiving surface of a monocrystalline or polycrystalline silicon wafer, an impurity of a conduction type opposite to that of the wafer so that a pn junction is formed, and forming electrodes at the light receiving surface and the back surface of the silicon wafer opposite to the light receiving surface, respectively. In the bifacial solar cell, it is also common to diffuse an impurity of the same conduction type as that of the silicon wafer into the back surface of the silicon wafer at a high concentration, thereby to achieve higher output by a back surface field effect.

Research and development is also being made on a back electrode type solar cell without an electrode formed at a light receiving surface of a semiconductor device but with an electrode formed only at the back surface (see, for example, Japanese Patent Laying-Open No. 2007-49079).

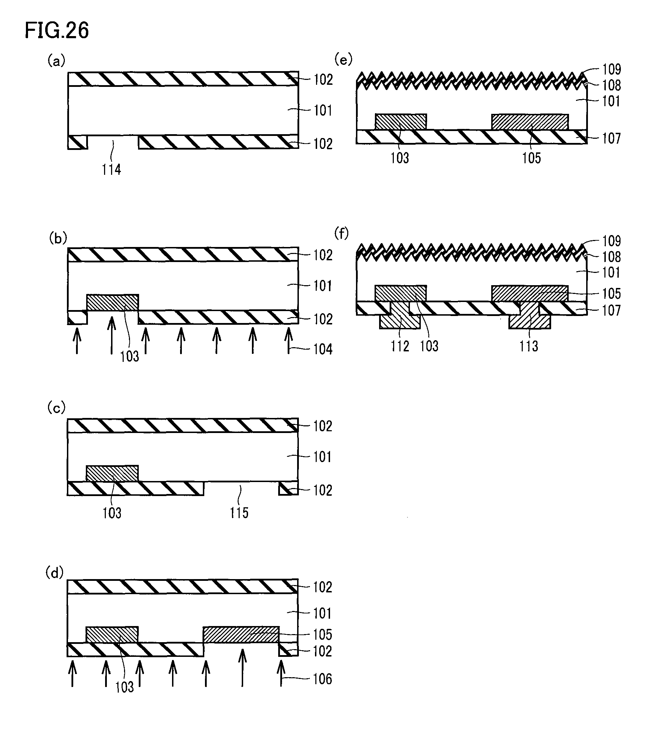

Hereinafter, reference will be made to Fig. 26(a) to Fig. 26(f) showing schematic cross sections to describe an example of a method for producing a conventional back electrode type solar cell.

Initially, as shown in Fig. 26(a), a masking paste 102 is screen-printed throughout a light receiving surface of a semiconductor substrate 101 having a conduction type of n type or p type and is dried, and subsequently, masking paste 102 is screen-printed on a back surface of semiconductor substrate 101 such that it partially has an opening 114.

Then, as shown in Fig. 26(b), an n type dopant 104 is diffused in semiconductor substrate 101 at the back surface through opening 114 to provide an n type dopant diffusion region 103.

Subsequently, masking paste 102 on the light receiving surface and back surface of semiconductor substrate 101 is all removed, and again, as shown in Fig. 26(c), masking paste 102 is screen-printed throughout the light receiving surface of semiconductor substrate 101 and is dried, and subsequently, masking paste 102 is screen-printed on the back surface of semiconductor substrate 101 such that it partially has an opening 115.

Then, as shown in Fig. 26(d), a p type dopant 106 is diffused in semiconductor substrate 101 at the back surface through opening 115 to provide a p type dopant diffusion region 105.

Then, as shown in Fig. 26(e), semiconductor substrate 101 has the light receiving surface etched and thus textured to have a textured structure 108, and thereafter, an anti-reflection film 109 is provided on textured structure 108 and a passivation film 107 is provided on the back surface of semiconductor substrate 101.

Thereafter, as shown in Fig. 26(f), openings are provided through passivation film 107 on the back surface of semiconductor substrate 101 to allow n type dopant diffusion region 103 and p type dopant diffusion region 105 to have surfaces, respectively, exposed therethrough, and thereafter an electrode for n type 112 is provided in contact with n type dopant diffusion region 103 through an opening and an electrode for p type 113 is provided in contact with p type dopant diffusion region 105 through an opening. The conventional back electrode type solar cell is thus produced.

Furthermore, Non-Patent Literature 1 (Yasuo Nishimura, "Discussion on Aqueous Solution of Sodium Hydroxide of High Concentration", the Toagosei group study annual report, TREND 2006, No. 9, pages 8-12) describes introducing aqueous solutions of NaOH having alkali concentrations of 51.9%, 48.0%, 35.0%, and 10.0% each into a cylindrical container, setting the solutions at 65°C, and subsequently immersing a 2-inch silicon wafer therein to etch the silicon wafer for 20 minutes and 30 minutes.

Furthermore, Non-Patent Literature 1 also describes that silicon wafers are etched with NaOH 48.0% and NaOH 51.9% for 20 minutes and 30 minutes, respectively, both at 65°C and have their surfaces measured in roughness, and as a result the product etched with the 48.0% solution has a surface roughness of 0.354 µm and the product etched with the 51.9% solution has a surface roughness of 0.216 µm, and the latter is thus better etched and higher alkali concentration thus allows a better etched state.

Note that in the field of the electronic devices that employ crystalline silicon, LSI in particular, mechanical polishing is typically used to allow a silicon wafer to have a surface improved in smoothness, whereas in the field of solar battery, chemical etching such as described in Non-Patent Literature 1 is a mainstream for high throughput and low cost.

### CITATION LIST

### PATENT LITERATURE

PTL 1: Japanese Patent Laying-Open No. 2007-49079.

### NON PATENT LITERATURE

NTL 1: Yasuo Nishimura, "Discussion on Aqueous Solution of Sodium Hydroxide of High Concentration", the Toagosei group study annual report, TREND 2006, No. 9, pages 8-12.

### SUMMARY OF INVENTION

### TECHNICAL PROBLEM

To constantly produce a back electrode type solar cell of satisfactory characteristics from a silicon wafer, it is effective to smooth a surface of the silicon wafer to be able to minimize contact resistance between the surface of the silicon wafer and an electrode and prevent carrier recombination at an interface between the surface of the silicon wafer and the electrode. Furthermore, it is also effective to print a masking paste with improved precision.

It is well known that when chemical etching is used to smooth a surface of a silicon wafer, as has been described above in the background art section, etching the silicon wafer in an increased amount facilitates the silicon wafer to have a smoother surface.

On the other hand, there is a demand for a silicon wafer reduced in thickness for a back electrode type solar cell for high throughput and low cost, and accordingly, crystalline silicon immediately after it is sliced has increasingly reduced thickness year after year. Under such circumstances, etching in an increased amount results in a silicon wafer impaired in mechanical strength and conversion efficiency.

Such an issue is not only an issue of the back electrode type solar cell, but also an issue of semiconductor devices, in general, including bifacial solar cell and other similar solar cells.

In view of the above circumstances, an object of the present invention is to provide a silicon wafer, a semiconductor device, a method for producing the silicon wafer, and a method for producing the semiconductor device, that allow a silicon wafer to have a smoother surface with only a limited etched amount to constantly produce a semiconductor device having satisfactory characteristics.

### SOLUTION TO PROBLEM

The present invention provides a silicon wafer obtained by etching by not less than 5 µm and not more than 25 µm per surface on either side a surface of crystalline silicon obtained by cutting a silicon crystal ingot, the silicon wafer having a surface with a facet having a width of not less than 10 µm and not more than 150 µm.

Preferably, the present silicon wafer has the facet that has a depth of not less than 0.1 µm and not more than 10 µm.

Furthermore, the present invention provides a semiconductor device including: the above silicon wafer; and an electrode provided on the silicon wafer at a surface having a facet.

Furthermore the present invention provides a method for producing a silicon wafer, including the steps of: forming crystalline silicon by cutting a silicon crystal ingot; and etching a surface of the crystalline silicon with an aqueous solution of sodium hydroxide having a sodium hydroxide concentration of not less than 20% by mass and not more than 35% by mass, and in the step of etching, the crystalline silicon is etched by an amount of not less than 5 µm and not more than 25 µm per surface on either side of the crystalline silicon.

In the present method for producing a silicon wafer the step of forming the crystalline silicon preferably includes the step of cutting the silicon crystal ingot with a wire saw.

Furthermore the present invention provides a method for producing a semiconductor device, including the steps of: forming crystalline silicon by cutting a silicon crystal ingot; etching a surface of the crystalline silicon with an aqueous solution of sodium hydroxide having a sodium hydroxide concentration of not less than 20% by mass and not more than 35% by mass to provide a silicon wafer having a surface with a facet having a width of not less than 10 µm and not more than 150 µm; and providing the silicon wafer with an electrode at the surface having the facet, and in the step of etching to provide the silicon wafer, the crystalline silicon is etched by an amount of not less than 5 µm and not more than 25 µm per surface on either side of the crystalline silicon.

In the present method for producing a semiconductor device, the step of forming the crystalline silicon preferably includes the step of cutting the silicon crystal ingot with a wire saw.

### ADVANTAGEOUS EFFECTS OF INVENTION

The present invention can thus provide a silicon wafer, a semiconductor device, a method for producing the silicon wafer, and a method for producing the semiconductor device, that allow a silicon wafer to have a smoother surface with only a limited etched amount to constantly produce a semiconductor device having satisfactory characteristics.

### BRIEF DESCRIPTION OF DRAWINGS

Fig. 1 is a schematic perspective view for illustrating an example of the step of forming crystalline silicon by cutting a silicon crystal ingot.
Fig. 2 is a schematic perspective view for illustrating an example of the step of forming crystalline silicon.
Fig. 3 is a schematic cross section of an example of a wire saw shown in Fig. 1.
Fig. 4 is a schematic cross section of an example of crystalline silicon obtained by cutting a silicon crystal ingot with a wire saw.
Fig. 5 is a schematic enlarged cross section of an example of a portion of a surface of the crystalline silicon shown in Fig. 4.
Fig. 6 is a schematic cross section of an example of a silicon wafer formed by etching a surface of crystalline silicon.
Fig. 7 is a schematic enlarged cross section of an example of a portion of a surface of the silicon wafer shown in Fig. 6.
Fig. 8 is a schematic enlarged cross section of an example of a facet of a surface of a silicon wafer.
Fig. 9 is a schematic enlarged cross section of another example of a facet of a surface of a silicon wafer.
Fig. 10 is a schematic enlarged cross section of still another example of a facet of a surface of a silicon wafer.
Fig. 11 (a) is a schematic cross section for illustrating an example of the step of applying a masking paste on a surface of a silicon wafer, and Fig. 11(b) is a schematic plan view as obtained when Fig. 11 (a) is seen at a back surface of the silicon wafer.
Fig. 12(a) is a schematic cross section for illustrating an example of the step of providing an n type dopant diffusion region in the back surface of the silicon wafer, and Fig. 12(b) is a schematic plan view as obtained when Fig. 12(a) is seen at the back surface of the silicon wafer.
Fig. 13(a) is a schematic cross section for illustrating an example of the step of applying a masking paste on a surface of the silicon wafer, and Fig. 13(b) is a schematic plan view as obtained when Fig. 13(a) is seen at the back surface of the silicon wafer.
Fig. 14(a) is a schematic cross section for illustrating an example of the step of providing a p type dopant diffusion region in the back surface of the silicon wafer, and Fig. 14(b) is a schematic plan view as obtained when Fig. 14(a) is seen at the back surface of the silicon wafer.
Fig. 15(a) is a schematic cross section for illustrating an example of the step of exposing the n type dopant diffusion region and the p type dopant diffusion region at the back surface of the silicon wafer, and Fig. 15(b) is a schematic plan view as obtained when Fig. 15(a) is seen at the back surface of the silicon wafer.
Fig. 16(a) is a schematic cross section for illustrating an example of the step of providing a passivation film on the back surface of the silicon wafer, and Fig. 16(b) is a schematic plan view as obtained when Fig. 16(a) is seen at the back surface of the silicon wafer.
Fig. 17(a) is a schematic cross section for illustrating an example of the step of providing a textured structure at a light receiving surface of the silicon wafer, and Fig. 17(b) is a schematic plan view as obtained when Fig. 17(a) is seen at the back surface of the silicon wafer.
Fig. 18(a) is a schematic cross section for illustrating an example of the step of providing an anti-reflection film on the textured structure of the silicon wafer, and Fig. 18(b) is a schematic plan view as obtained when Fig. 18(a) is seen at the back surface of the silicon wafer.
Fig. 19(a) is a schematic cross section for illustrating an example of the step of providing a contact hole through the passivation film on the back surface of the silicon wafer, and Fig. 19(b) is a schematic plan view as obtained when Fig. 19(a) is seen at the back surface of the silicon wafer.
Fig. 20(a) is a schematic cross section for illustrating an example of the step of providing an electrode for n type and an electrode for p type, and Fig. 20(b) is a schematic plan view as obtained when Fig. 20(a) is seen at the back surface of the silicon wafer.
Fig. 21 is an enlarged photographic image of a wire saw used in an Example of the invention.
Fig. 22 is a microscopic image of an example of a surface of n type monocrystalline silicon after it is cut with the wire saw shown in Fig. 21.
Fig. 23(a) is a microscopic image of a portion of a surface of a silicon wafer of the Example of the invention, and Fig. 23(b) shows a result of measuring the surface of the silicon wafer of the Example of Fig. 23(a) in unevenness with a laser microscope.
Fig. 24(a) is a microscopic image of a portion of a surface of a silicon wafer of a Comparative Example 1, and Fig. 24(b) shows a result of measuring the surface of the silicon wafer of Comparative Example 1 of Fig. 24(a) in unevenness with a laser microscope.
Fig. 25(a) is a microscopic image of a portion of a surface of a silicon wafer of Comparative Example 2, and Fig. 25(b) shows a result of measuring the surface of the silicon wafer of Comparative Example 2 of Fig. 25(a) in unevenness with a laser microscope.
Fig. 26(a) to Fig. 26(f) are schematic cross sections for illustrating an example of a method for producing a back electrode type solar cell as conventional.

### DESCRIPTION OF EMBODIMENTS

Hereinafter, the present invention will be described in an embodiment. Note that in the figures, identical or corresponding portions are identically denoted.

### <Method for Producing Silicon Wafer>

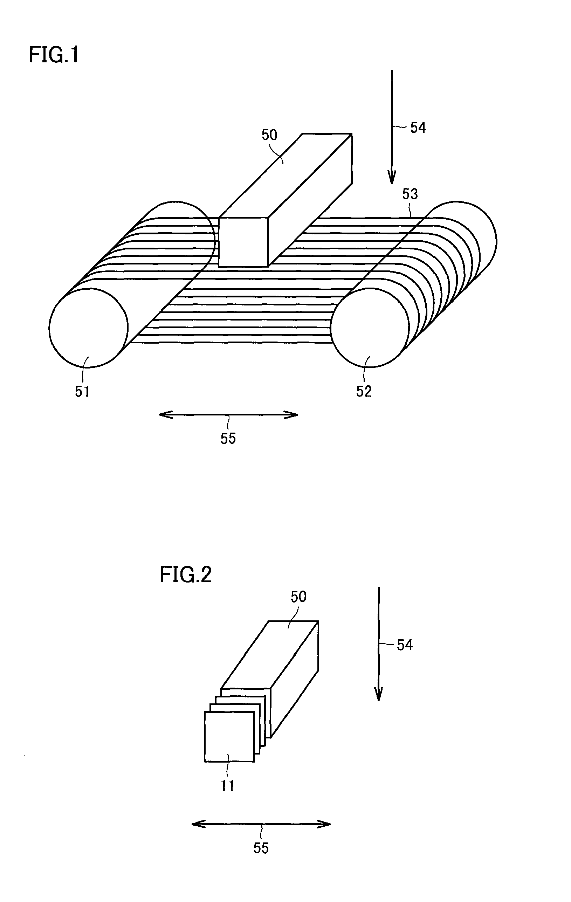

As an example of the step of forming crystalline silicon by cutting a silicon crystal ingot, the step of cutting a silicon crystal ingot 50 with a wire saw 53 is performed, as shown in the schematic perspective view of Fig. 1.

As shown in Fig. 1, wire saw 53 is wound on and between guide rollers 51 and 52 spaced as predetermined. As a result, wire saw 53 is tensioned on guide rollers 51 and 52 at a plurality of locations spaced as predetermined in a longitudinal direction of guide rollers 51 and 52. In this condition, guide rollers 51 and 52 are rotated back and forth to allow wire saw 53 to reciprocate in a direction indicated by an arrow 55.

While wire saw 53 is reciprocating in the direction of arrow 55, silicon crystal ingot 50 is moved in a direction indicated by an arrow 54. Silicon crystal ingot 50 is pressed against wire saw 53 that is reciprocating, and, for example as shown in the schematic perspective view of Fig. 2, silicon crystal ingot 50 is cut at a plurality of locations to form a plurality of plates of crystalline silicon 11.

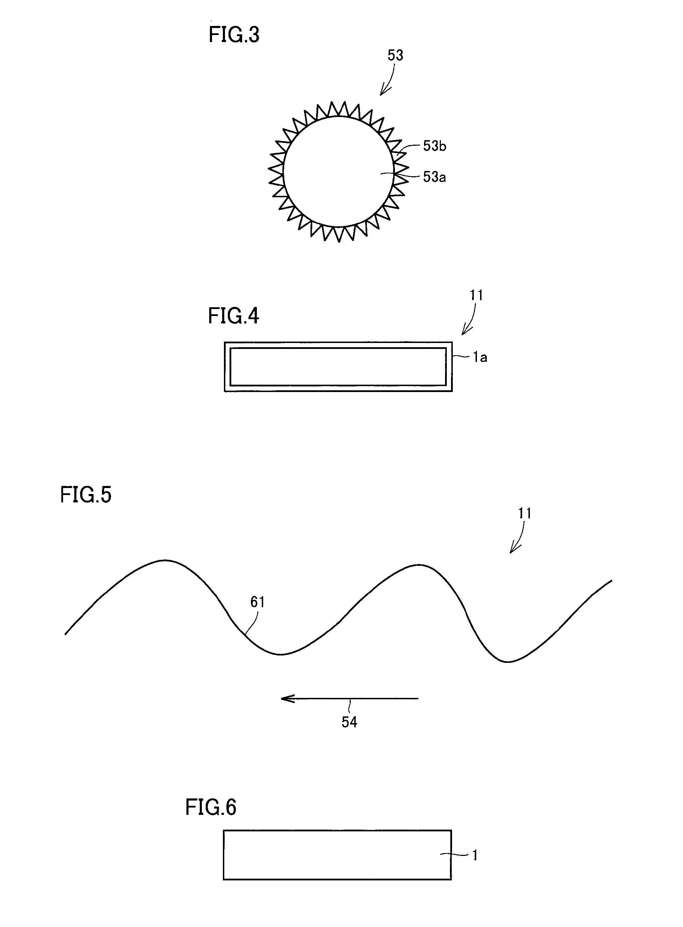

Fig. 3 shows a schematic cross section of an example of wire saw 53 shown in Fig. 1. Herein, wire saw 53 includes a core wire 53a and abrasive grains 53b bonded to an external, circumferential surface of core wire 53a with a bonding material (not shown). Core wire 53a can be implemented for example as piano wire. Abrasive grains 53b can for example be abrasive grains of diamond and the bonding material can for example be nickel or the like plated on the external surface of core wire 53a.

Silicon crystal ingot 50 is a monocrystalline silicon ingot or a polycrystalline silicon ingot or the like produced in the Czochralski method or casting, for example. Note that silicon crystal ingot 50 may be doped with an n or p type dopant to have an n or p type conduction type.

Fig. 4 shows a schematic cross section of an example of crystalline silicon 11 obtained by cutting silicon crystal ingot 50 with wire saw 53. Herein, crystalline silicon 11 has a surface with a slicing damage 1a caused as silicon crystal ingot 50 is cut with wire saw 53.

Fig. 5 shows a schematic enlarged cross section of an example of a portion of a surface of crystalline silicon 11 shown in Fig. 4. As shown in Fig. 5, crystalline silicon 11 has a surface with a large wave (hereinafter referred to as a "saw mark") 61.

Saw mark 61 is caused as wire saw 53 is used to cut silicon crystal ingot 50. More specifically, as shown in Fig. 1, crystalline silicon 11 is obtained by pressing silicon crystal ingot 50 against wire saw 53 that is reciprocating to cut silicon crystal ingot 50, and whenever direction 55 in which wire saw 53 travels is switched, wire saw 53 temporarily stops and its linear velocity falls. Wire saw 53 thus cuts into silicon crystal ingot 50 differently in depth in a direction in which silicon crystal ingot 50 moves relative to wire saw 53, (i.e., in the direction of arrow 54), and this appears as a saw mark 61 that is a large wave, at a surface of crystalline silicon 11.

Then, the step of etching a surface of crystalline silicon 11 is performed. This can remove slicing damage 1a of the surface of crystalline silicon 11 shown in Fig. 4 and also form a recess in the form of a crater (or facet) in the surface of crystalline silicon 11.

The step of etching the surface of crystalline silicon 11 is performed by etching a surface of crystalline silicon 11 with an aqueous solution of sodium hydroxide having a sodium hydroxide concentration of not less than 20% by mass and not more than 35% by mass, preferably not less than 24% by mass and not more than 32% by mass, by an amount of not less than 5 µm and not more than 25 µm in thickness per surface on either side of crystalline silicon 11. This is a result of the present inventors having diligently studied to find that when the aqueous solution of sodium hydroxide having a sodium hydroxide concentration of not less than 20% by mass and not more than 35% by mass, preferably not less than 24% by mass and not more than 32% by mass, is used to etch a surface of crystalline silicon 11, crystalline silicon 11 etched by a thickness of not less than 5 µm and not more than 25 µm per surface on either side thereof allows a silicon wafer to have a surface further better in smoothness than when an aqueous solution of sodium hydroxide having a sodium hydroxide concentration higher than 35% by mass is used to etch crystalline silicon 11 by the same thickness. For example, etching crystalline silicon 11 with an aqueous solution of sodium hydroxide having a sodium hydroxide concentration of 30% by mass by a thickness of 13 µm per surface on either side thereof allows a silicon wafer to have a surface equivalent in smoothness to that obtained by etching crystalline silicon 11 with an aqueous solution of sodium hydroxide having a sodium hydroxide concentration of 48% by mass by a thickness of about 30 µm per surface on either side thereof, as conventional. The silicon wafer that has a surface improved in smoothness can have the surface in contact with an electrode over an increased area, which can contribute to reduced contact resistance between the surface of the silicon wafer and the electrode and reduced carrier recombination at an interface therebetween, and the silicon wafer with the surface improved in smoothness also allows a masking paste to be printed thereon with improved precision, which can contribute to improved shunt resistance and reduced reverse saturation current. Furthermore, the reduced etched amount prevents the silicon wafer from having poor mechanical strength and a solar cell produced therefrom from having poor conversion efficiency. Thus etching as done in the present embodiment allows a silicon wafer to be produced to allow a semiconductor device to be constantly produced with satisfactory characteristics.

Herein, crystalline silicon 11 is etched per surface on either side thereof by an amount (or depth) preferably of not less than 5 µm and not more than 20 µm and more preferably not less than 5 µm and not more than 15 µm. If crystalline silicon 11 is etched per surface on either side thereof by an amount of not less than 5 µm and not more than 20 µm, not less than 5 µm and not more than 15 µm in particular, such a tendency increases that crystalline silicon 11 can be etched per surface on either side thereof in a further limited amount and also allows a silicon wafer to have a surface improved in smoothness.

Note that in the present specification, when crystalline silicon 11 has a surface etched by an amount, the amount means an amount of crystalline silicon 11 that is reduced in thickness (in µm), as seen its depthwise direction, per surface on either side thereof.

### <Silicon Wafer>

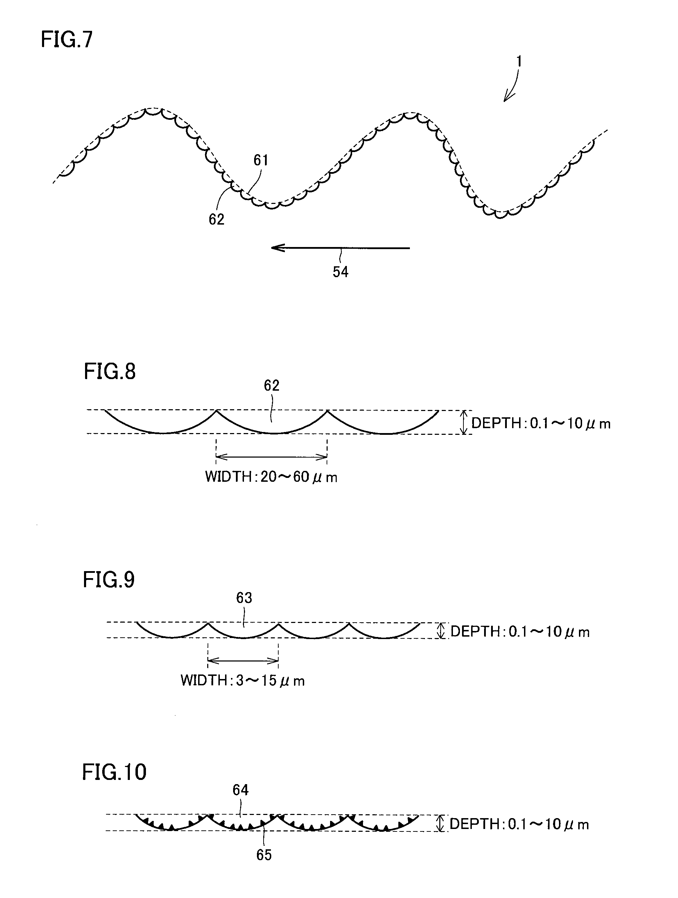

Fig. 6 shows a schematic cross section of an example of the silicon wafer formed by etching a surface of crystalline silicon 11, as described above, and Fig. 7 shows a schematic enlarged cross section of a portion of an example of a surface of a silicon wafer 1 shown in Fig. 6.

While silicon wafer 1 no longer has a surface damaged by slicing, as shown in Fig. 6, silicon wafer 1 has a facet 62 formed as a result of etching with an aqueous solution of sodium hydroxide of the aforementioned concentration, as shown in Fig. 7. Note that while silicon wafer 1 may also have a surface having an abrasive trace formed by abrasive grains 53b of wire saw 53, Fig. 7 omits the description for convenience of illustration.

Fig. 8 shows a schematic enlarged cross section of an example of facet 62 shown in Fig. 7. When an aqueous solution of sodium hydroxide having a sodium hydroxide concentration of not less than 20% by mass and not more than 35% by mass, preferably not less than 24% by mass and not more than 32% by mass, is used to etch crystalline silicon 11 by a thickness of not less than 5 µm and not more than 25 µm, preferably not less than 5 µm and not more than 20 µm, more preferably not less than 5 µm and not more than 15 µm, per surface on either side thereof, silicon wafer 1 has a surface having facet 62 formed with a width of not less than 10 µm and not more than 150 µm, preferably not less than 20 µm and not more than 150 µm, and a depth of not less than 0.1 µm and not more than 10 µm. For example, etching crystalline silicon 11 with an aqueous solution of sodium hydroxide having a sodium hydroxide concentration of 30% by mass by 13 µm per surface on either side thereof provides a silicon wafer having a surface with facet 62 having a width for example of not less than 20 µm and not more than 60 µm, as shown in Fig. 8.

In contrast, as shown in the schematic enlarged cross section of Fig. 9, when an aqueous solution of sodium hydroxide having a sodium hydroxide concentration larger than 35% by mass is used to etch crystalline silicon 11 by not less than 5 µm and not more than 25 µm per surface on either side thereof, silicon wafer 1 has a surface having a facet 63 formed with a width significantly narrower than when an aqueous solution of sodium hydroxide having a sodium hydroxide concentration of not less than 20% by mass and not more than 35% by mass is used to etch crystalline silicon 11 by the same amount, and with a depth of not less than 0.1 µm and not more than 10 µm. For example, etching crystalline silicon 11 with an aqueous solution of sodium hydroxide having a sodium hydroxide concentration of 48% by mass by 13 µm per surface on either side thereof provides a silicon wafer having a surface with facet 63 having a width for example of not less than 3 µm and not more than 15 µm, as shown in Fig. 9.

Furthermore, as shown in the schematic enlarged cross section of Fig. 10, when an aqueous solution of sodium hydroxide having a sodium hydroxide concentration smaller than 20% by mass is used to etch crystalline silicon 11 by not less than 5 µm and not more than 25 µm per surface on either side thereof, silicon wafer 1 has a surface having a facet 64 formed with a pyramidal projection 65 formed therein.

Thus etching with an aqueous solution of sodium hydroxide having a sodium hydroxide concentration of not less than 20% by mass and not more than 35% by mass, preferably not less than 24% by mass and not more than 32% by mass, by a thickness of not less than 5 µm and not more than 25 µm, preferably not less than 5 µm and not more than 20 µm, more preferably not less than 5 µm and not more than 15 µm, provides silicon wafer 1 that has a surface with facet 62 having a width of not less than 10 µm and not more than 150 µm, preferably not less than 20 µm and not more than 150 µm, and a depth of not less than 0.1 µm and not more than 10 µm, and hence smoother than otherwise. It is obvious that when such a smooth surface provided with an electrode is compared with a surface that has facet 63 smaller in width and hence is not smooth, as shown in Fig. 9, provided with the electrode, or a surface that has facet 64 with projection 65 formed therein and hence is not smooth, as shown in Fig. 10, provided with the electrode, the former allows reduced contact resistance between the silicon wafer and the electrode and reduced carrier recombination at the interface between the surface of the silicon wafer and the electrode. Furthermore, it is obvious that when such a smooth surface with a masking paste printed thereon is compared with a surface that has facet 63 smaller in width and hence is not smooth, as shown in Fig. 9, with the masking paste printed thereon, or a surface that has facet 64 with projection 65 formed therein and hence is not smooth, as shown in Fig. 10, with the masking paste printed thereon, the former can have the masking paste printed thereon with improved precision. Thus etching with an aqueous solution of sodium hydroxide having a sodium hydroxide concentration of not less than 20% by mass and not more than 35% by mass, preferably not less than 24% by mass and not more than 32% by mass, by a thickness of not less than 5 µm and not more than 25 µm, preferably not less than 5 µm and not more than 20 µm, more preferably not less than 5 µm and not more than 15 µm, can provide silicon wafer 1 allowing a semiconductor device having satisfactory characteristics to be constantly produced.

Preferably, not less than 90% of facets 62 formed on a surface of silicon wafer 1 are facets 62 of not less than 10 µm and not more than 150 µm, preferably not less than 20 µm and not more than 150 µm in width, and not less than 0.1 µm and not more than 10 µm in depth. This provides an increased tendency that silicon wafer 1 has a further smoother surface allowing a semiconductor device having satisfactory characteristics to be constantly produced.

### <Method for Producing Semiconductor Device>

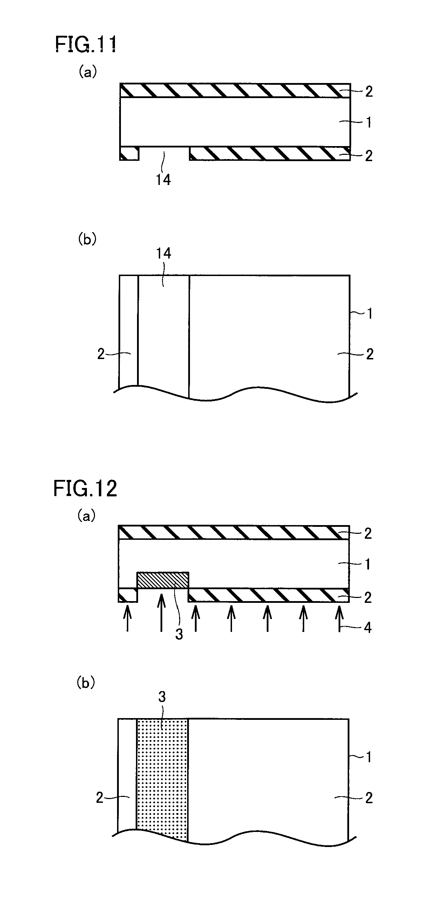

Hereinafter, reference will be made to Fig. 11 to Fig. 20 to describe a method for producing a back electrode type solar cell of an embodiment that is an example of a method for producing a semiconductor device of the present invention.

Initially, as shown in the schematic cross section of Fig. 11(a) and the schematic plan view of Fig. 11(b), a masking paste 2 is applied throughout a light receiving surface of silicon wafer 1 of n type or p type formed by the above described etching to have facet 62 large in width, and masking paste 2 is also applied in a strip on a back surface of silicon wafer 1 such that it partially has an opening 14. Note that Fig. 11(b) is a schematic plan view as obtained when Fig. 11 (a) is seen at the back surface of silicon wafer 1. The above etching is done by etching with an aqueous solution of sodium hydroxide having a sodium hydroxide concentration of not less than 20% by mass and not more than 35% by mass, preferably not less than 24% by mass and not more than 32% by mass, by a thickness of not less than 5 µm and not more than 25 µm, preferably not less than 5 µm and not more than 20 µm, more preferably not less than 5 µm and not more than 15 µm per surface on either side, and it is done for each of the light receiving surface of silicon wafer 1 and the back surface of silicon wafer 1.

Masking paste 2 can for example be one that contains a solvent, a thickener, and a silicon oxide precursor and/or a titanium oxide precursor. Masking paste 2 can also be one that does not contain thickener.

the solvent can for example be ethylene glycol, methyl cellosolve, methyl cellosolve acetate, ethyl cellosolve, diethyl cellosolve, cellosolve acetate, ethylene glycol monophenyl ether, methoxyethanol, ethylene glycol monoacetate, ethylene glycol diacetate, diethylene glycol, diethylene glycol monomethyl ether, diethylene glycol monoethyl ether acetate, diethylene glycol monobutyl ether, diethylene glycol monobutyl ether acetate, diethylene glycol dimethyl ether, diethylene glycol methyl ethyl ether, diethylene glycol diethyl ether, diethylene glycol acetate, triethyl glycol, triethylene glycol monomethyl ether, triethylene glycol monoethyl ether, tetraethylene glycol, liquid polyethylene glycol, propylene glycol, propylene glycol monomethyl ether, propylene glycol monoethyl ether, propylene glycol monobutyl ether, 1-butoxyethoxypropanol, dipropylglycol, dipropylene glycol monomethyl ether, dipropylene glycol monoethyl ether, tripropylene glycol monomethyl ether, polypropylene glycol, trimethylene glycol, butanedial, 1,5-pentanedial, hexylene glycol, glycerol, glyceryl acetate, glycerol diacetate, glyceryl triacetate, trimethylol propyne, 1,2,6-hexanetriol, 1,2-propanediol, 1,5-pentanediol, octanediol, 1,2-butanediol, 1,4-butanediol, 1,3-butanediol, dioxane, trioxane, tetrahydrofuran, tetrahydropyran, methylal, diethyl acetal, methyl ethyl ketone, methyl isobutyl ketone, diethyl ketone, acetonylacetone, diacetone alcohol, methyl formate, ethyl formate, propyl formate, methyl acetate, ethyl acetate, or a combination of two or more thereof.

Desirably, the thickener is ethyl cellulose, polyvinylpyrrolidone, or a mixture thereof, however, the thickener can also be bentonite of a variety of qualities and properties, a generally inorganic rheology additive for various polar solvent mixtures, nitrocellulose and other cellulose compounds, starch, gelatin, alginic acid, highly-dispersive amorphous silicic acid (Aerosil®), polyvinyl butyral (Mowital®), sodium carboxymethylcellulose (vivistar), thermoplastic polyamide resin (Eurelon®), an organic castor oil derivative (Thixin R®), diamide wax (Thixatrol plus®), swelable polyacrylate (Rheolate®), polyether urea polyurethane, polyether polyol, or the like.

The silicon oxide precursor can for example be a substance represented by a general formula R^{1'}ₙSi(OR¹) ₄₋ₙ, such as TEOS (tetraethyl orthosilicate), wherein R^{1'} represents methyl, ethyl, or phenyl, R¹ represents methyl, ethyl, n-propyl or i-propyl, and n represents 0, 1 or 2.

The titanium oxide precursor includes, for example, Ti (OH)₄, and, other than that, a substance represented by R^{2'}ₙTi(OR²)₄₋ₙ, such as TPT (tetra isopropoxy titanium), wherein R^{2'} represents methyl, ethyl, or phenyl, R² represents methyl, ethyl, n-propyl, or i-propyl, and n represents 0, 1, or 2, as well as TiCl₄, TiF₄, TiOSO₄ and the like.

If the thickener is used, it can for example be castor oil, bentonite, nitrocellulose, ethyl cellulose, polyvinyl pyrrolidone, starch, gelatin, alginic acid, amorphous silicic acid, polyvinyl butyral, sodium carboxymethylcellulose, polyamide resin, organic castor oil derivative, diamide wax, swelable polyacrylate, polyether urea-polyurethane, polyether polyol, or a combination of two or more thereof.

Masking paste 2 may be applied in any manner, and it can be applied for example in a conventionally known method.

Subsequently, masking paste 2 provided on the light receiving surface and back surface of silicon wafer 1 is dried.

Masking paste 2 can be dried in a method for example as follows: after masking paste 2 is applied, silicon wafer 1 therewith is introduced in an oven to heat masking paste 2 for example at a temperature of about 300°C for example for several tens minutes.

Then, masking paste 2 thus dried is fired and thus solidified. Masking paste 2 can be fired for example at a temperature of not less than 800°C and not more than 1000°C for example for a period of not less than 10 minutes and not more than 60 minutes.

Then, as shown in the schematic cross section of Fig. 12(a) and the schematic plan view of Fig. 12(b), n type dopant containing gas 4 is introduced to diffuse n type dopant in the back surface of silicon wafer 1 exposed through opening 14 provided at the back surface of silicon wafer 1 to form an n type dopant diffusion region 3 in the form of a strip. Note that n type dopant containing gas 4 can for example be POCl₃ containing phosphorus serving as n type dopant, for example. Furthermore, n type dopant diffusion region 3 is a region having a higher n type dopant concentration than silicon wafer 1. Note that Fig. 12(b) is a schematic plan view as obtained when Fig. 12(a) is seen at the back surface of silicon wafer 1.

Subsequently, masking paste 2 provided on the light receiving surface and back surface of silicon wafer 1 is all once removed. Masking paste 2 can be removed for example by immersing silicon wafer 1 with masking paste 2 in an aqueous solution of fluoric acid.

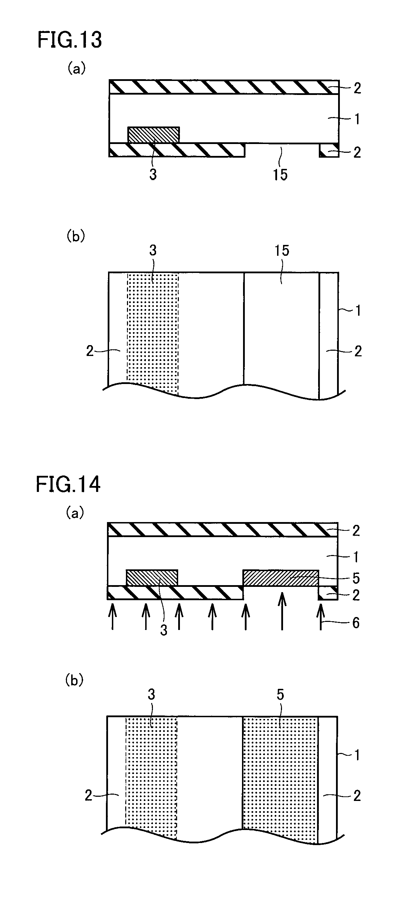

Then, as shown in the schematic cross section of Fig. 13(a) and the schematic plan view of Fig. 13(b), masking paste 2 is applied throughout the light receiving surface of silicon wafer 1, and masking paste 2 is also applied on the back surface of silicon wafer 1 such that it has an opening 15. Opening 15 is formed at a location different from that of opening 14. Note that Fig. 13(b) is a schematic plan view as obtained when Fig. 13(a) is seen at the back surface of silicon wafer 1.

Then, masking paste 2 applied on the light receiving surface and back surface of silicon wafer 1 is dried, and masking paste 2 is then fired and thus solidified.

Then, as shown in the schematic cross section of Fig. 14(a) and the schematic plan view of Fig. 14(b), p type dopant containing gas 6 is introduced to diffuse p type dopant in the back surface of silicon wafer 1 exposed through opening 15 provided at the back surface of silicon wafer 1 to form a p type dopant diffusion region 5 in the form of a strip. Note that p type dopant containing gas 6 can be BBr₃ or the like containing boron serving as p type dopant, for example. Furthermore, p type dopant diffusion region 5 is a region having a higher p type dopant concentration than silicon wafer 1. Note that Fig. 14(b) is a schematic plan view as obtained when Fig. 14(a) is seen at the back surface of silicon wafer 1.

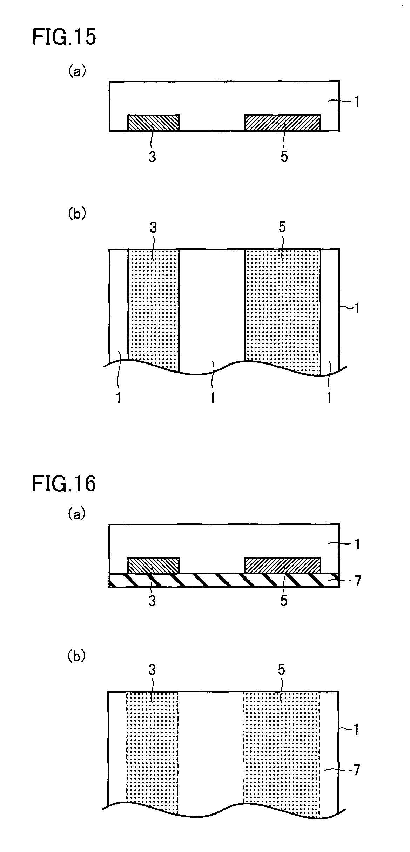

Then, as shown in the schematic cross section of Fig. 15(a) and the schematic plan view of Fig. 15(b), masking paste 2 provided on the light receiving surface and back surface of silicon wafer 1 is all removed. This can expose the light receiving surface and back surface of silicon wafer 1 entirely, and can expose strip-shaped n type dopant diffusion region 3 and strip-shaped p type dopant diffusion region 5. Note that Fig. 15(b) is a schematic plan view as obtained when Fig. 15(a) is seen at the back surface of silicon wafer 1.

Then, as shown in the schematic cross section of Fig. 16(a) and the schematic plan view of Fig. 16(b), a passivation film 7 is provided on the back surface of silicon wafer 1. Passivation film 7 can for example be silicon oxide film, silicon nitride film, silicon oxide film and silicon nitride film deposited in layers, or the like. Passivation film 7 can be provided for example through plasma CVD. Note that Fig. 16(b) is a schematic plan view as obtained when Fig. 16(a) is seen at the back surface of silicon wafer 1.

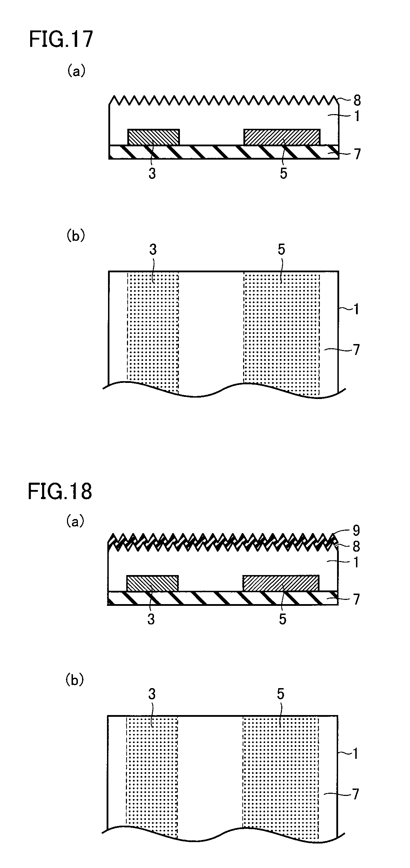

Then, as shown in the schematic cross section of Fig. 17(a) and the schematic plan view of Fig. 17(b), silicon wafer 1 has a side opposite to that with passivation film 7, i.e., the light receiving surface, subjected to texture-etching to form a textured structure 8. The texture etching for forming textured structure 8 can be performed by using passivation film 7 provided on the back surface of silicon wafer 1 as an etching mask. Note that texture etching can be performed by etching the light receiving surface of silicon wafer 1 with an etching liquid that is a liquid of an alkaline aqueous solution for example of sodium hydroxide, potassium hydroxide or the like with isopropyl alcohol added thereto and is heated for example to not less than 70°C and not more than 80°C.

Then, as shown in the schematic cross section of Fig. 18(a) and the schematic plan view of Fig. 18(b), an anti-reflection film 9 is provided on textured structure 8 of silicon wafer 1. Anti-reflection film 9 can for example be silicon oxide film, silicon nitride film, silicon oxide film and silicon nitride film deposited in layers, or the like. Anti-reflection film 9 can be provided for example through plasma CVD. Note that Fig. 18(b) is a schematic plan view as obtained when Fig. 18(a) is seen at the back surface of silicon wafer 1.

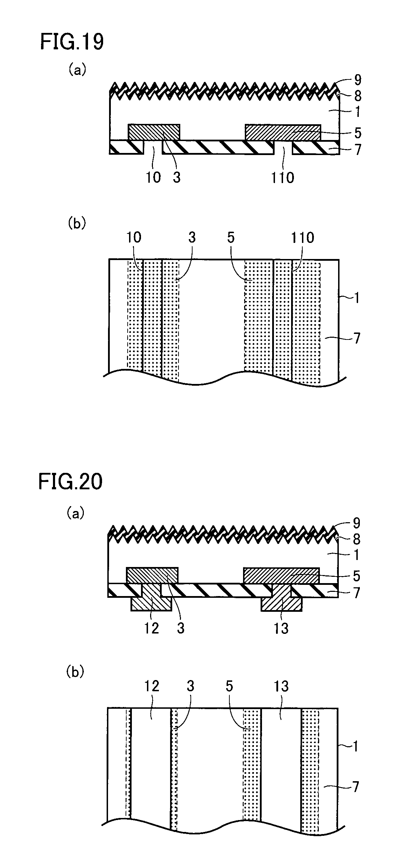

Then, as shown in the schematic cross section of Fig. 19(a) and the schematic plan view of Fig. 19(b), passivation film 7 is partially removed to form a contact hole 10 and a contact hole 110 to expose a portion of n type dopant diffusion region 3 through contact hole 10 and a portion of p type dopant diffusion region 5 through contact hole 110. Note that Fig. 19(b) is a schematic plan view as obtained when Fig. 19(a) is seen at the back surface of silicon wafer 1.

Contact holes 10 and 11 can be formed for example as follows: photolithography is used to provide on passivation film 7 a resist pattern having openings at portions corresponding to locations at which contact holes 10 and 11 will be provided, and thereafter passivation film 7 is etched away through the openings of the resist pattern.

Then, as shown in the schematic cross section of Fig. 20(a), and the schematic plan view of Fig. 20(b), an electrode for n type 12 electrically connected to n type dopant diffusion region 3 through contact hole 10 is provided, and an electrode for p type 13 electrically connected to p type dopant diffusion region 5 through contact hole 110 is provided. Herein, electrode for n type 12 and electrode for p type 13 can be implemented as electrodes formed of metal such as silver, for example. A back electrode type solar cell can thus be produced.

### <Semiconductor Device>

The back electrode type solar cell produced as described above can have electrode for n type 12 and electrode for p type 13 on a smooth back surface of silicon wafer 1 that has wide facet 62, as shown in Fig. 20(a), and the back surface of silicon wafer 1 and electrodes for n and p types 12 and 13 can contact each other over an increased area, which can contribute to reduced contact resistance between silicon wafer 1 and the electrodes (electrode for n type 12 and electrode for p type 13) and reduced carrier recombination at an interface between the surface of the silicon wafer and the electrodes. Furthermore, as silicon wafer 1 has a less uneven back surface, masking paste 2 can be printed thereon in a less irregular pattern and hence with improved precision. Furthermore, silicon wafer 1 can be formed with a smaller etched amount than conventional, which can prevent silicon wafer 1 from having poor mechanical strength and a back electrode type solar cell produced therefrom from having poor conversion efficiency. Accordingly, the back electrode type solar cell produced as described above can be produced constantly with satisfactory characteristics.

Furthermore, the present invention is not limited to application to the back electrode type solar cell, and can also be applied to semiconductor devices of any configurations.

### Examples

### <Production and Assessment of Silicon Wafer>

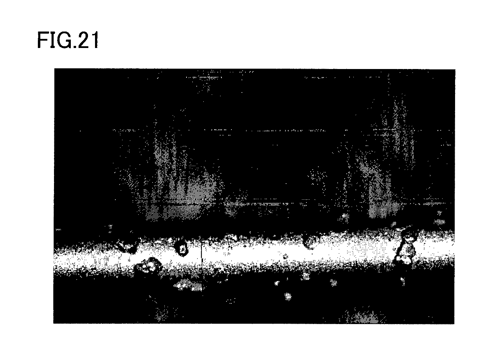

Initially, an n type monocrystalline silicon ingot prepared in the Czochralski method was pressed to a reciprocating wire saw, which is shaped as shown in an enlarged photographic image shown in Fig. 21, and thus cut. This produced a plurality of 200-µm-thick plates of n type monocrystalline silicon each having a light receiving surface and a back surface each in a pseudo square with each side having a length of 126 mm. The wire saw shown in Fig. 21 was a piano wire having a diameter of 120 µm in cross section and an external, circumferential surface plated with nickel to adhere thereto abrasive grains of diamond having a particle diameter of not more than 30 µm.

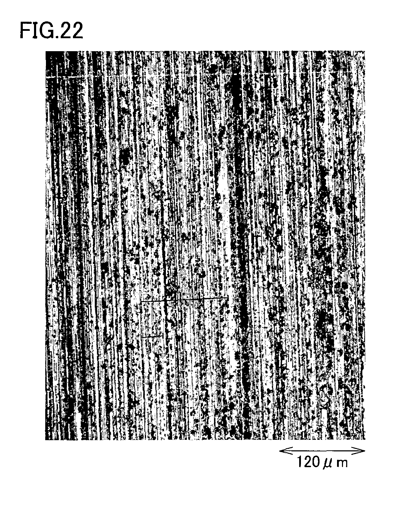

Fig. 22 is a microscopic image of an example of a surface of the n type monocrystalline silicon after it was cut with the wire saw. As shown in Fig. 22, it has been confirmed that the n type monocrystalline silicon had a surface having abrasive traces formed by the abrasive grains in the form of grooves formed in a direction in which the wire saw traveled, as indicated in Fig. 22 by vertical lines.

Then, the n type monocrystalline silicon provided as described above had a surface etched with an aqueous solution of sodium hydroxide having a sodium hydroxide concentration of 30% by mass by an amount of 13 µm per surface on either side (the both sides had their respective surfaces etched by an amount of 26 µm in total and the etched n type monocrystalline silicon consequently had a thickness of 174 µm). This provided a silicon wafer having a surface which had a slicing damage removed therefrom and also had a wide facet (hereinafter referred to as a "silicon wafer of the example of the invention).

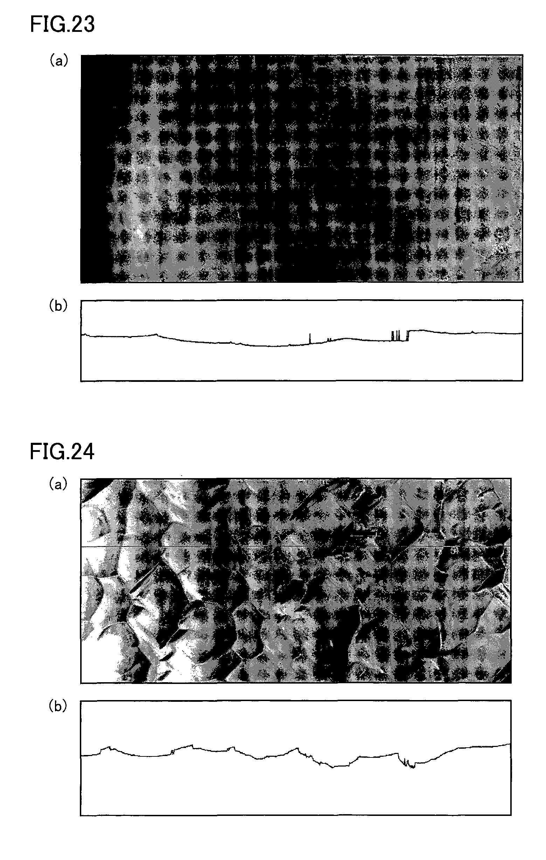

Fig. 23(a) is a microscopic image of a portion of a surface of the silicon wafer of an Example of the invention produced as described above, and Fig. 23(b) shows a result of measuring the surface of the silicon wafer of the Example of Fig. 23(a) in unevenness with a laser microscope. As shown in Fig. 23(a) and Fig. 23(b), it has been confirmed that the present example's silicon wafer had a smooth surface. Furthermore, the silicon wafer of the Example had the surface with facets, 90% of which were facets having a width of not less than 20 µm and not more than 60 µm and a depth of not less than 0.1 µm and not more than 10 µm.

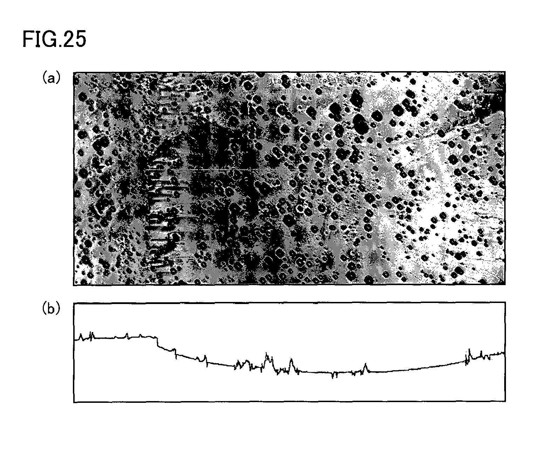

Furthermore, for comparison, except that a 234 µm thick plate of n type monocrystalline silicon had a surface etched with an aqueous solution of sodium hydroxide having a sodium hydroxide concentration of 48% by mass by an amount of 30 µm per surface on either side (the both sides had their respective surfaces etched by an amount of 60 µm in total and the etched n type monocrystalline silicon consequently had a thickness of 174 µm), a silicon wafer was produced, similarly as done in the Example of the invention (hereinafter referred to as a "silicon wafer of Comparative Example 1"), and furthermore, except that n type monocrystalline silicon had a surface etched with an aqueous solution of sodium hydroxide having a sodium hydroxide concentration of 18% by mass by an amount of 13 µm per surface on either side, a silicon wafer was produced, similarly as done in the example of the invention (hereinafter referred to as a "silicon wafer of Comparative Example 2"). Fig. 24(a) and Fig. 25(a) show a microscopic image of a portion of a surface of the silicon wafer of Comparative Example 1, and a microscopic image of a portion of a surface of the silicon wafer of Comparative Example 2, respectively. Fig. 24(b) shows a result of measuring the surface of the silicon wafer of Comparative Example 1 of Fig. 24(a) in unevenness with a laser microscope, and Fig. 25(b) shows a result of measuring the surface of the silicon wafer of Comparative Example 2 of Fig. 25(a) in unevenness with a laser microscope.

As shown in Fig. 24(a) and Fig. 24(b), it has been confirmed that the silicon wafer of Comparative Example 1 had a less smooth surface than that of the silicon wafer of the Example of the invention. Furthermore, as shown in Fig. 25(a) and Fig. 25(b), it has been confirmed that the silicon wafer of Comparative Example 2 had a surface with pyramidal projections (as shown in Fig. 25(a) as black spots).

It has also been confirmed that silicon wafers produced in a manner similar to that for the silicon wafer of the Example of the invention, except for sodium hydroxide concentrations of 20% by mass, 24% by mass, 32% by mass, and 35% by mass, also had surfaces, respectively, similar to that of the silicon wafer of the Example of the invention.

Furthermore, when silicon wafers produced in a manner similar to that for the silicon wafer of the Example of the invention except that they were etched by amounts of 5 µm, 15 µm, 20 µm, and 25 µm, respectively, per surface on either side, were compared with silicon wafers produced in a manner similar to that for the silicon wafer of the Example of the invention except that they were etched with an aqueous solution of sodium hydroxide having a sodium hydroxide concentration of 48% by mass by amounts of 5 µm, 15 µm, 20 µm, and 25 µm, respectively, per surface on either side, it has been confirmed that the former had facet larger in size than the latter for the equal etched amounts.

### <Production and Assessment of Back Electrode Type Solar Cell>

The silicon wafer of the Example of the invention, the silicon wafer of Comparative Example 1, and the silicon wafer of Comparative Example 2 were used to produce a back electrode type solar cell of the Example of the invention, a back electrode type solar cell of Comparative Example 1, and a back electrode type solar cell of Comparative Example 2, respectively.

Specifically, initially, a masking paste was printed throughout one surface of each of the silicon wafer of the Example of the invention, the silicon wafer of Comparative Example 1, and the silicon wafer of Comparative Example 2, and a strip-shaped masking paste was printed on the opposite surface such that a plurality of openings were provided.

After the masking paste was printed, the silicon wafers therewith were introduced in an oven to heat and thus dry the masking paste.

The masking paste thus dried was then heated and fired and thus solidified.

After the masking paste was solidified, the silicon wafers were exposed to POCl₃ to diffuse phosphorus in each silicon wafer through an opening to provide an n type dopant diffusion region.

Then, the silicon wafers were immersed in an aqueous solution of fluoric acid to remove the masking paste therefrom entirely.

Then, the masking paste was printed on each silicon wafer at the surface with the n type dopant diffusion region such that a plurality of strip-shaped openings were exposed parallel to the n type dopant diffusion region. Herein, the masking paste was printed so that a region different from the n type dopant diffusion region was exposed through the opening.

Furthermore, the masking paste was also printed on each silicon wafer throughout a surface opposite to that with the n type dopant diffusion region.

Then the silicon wafers were introduced in the oven and heated therein to dry the masking paste, and thereafter the masking paste was heated and fired and thus solidified.

The silicon wafers were then exposed to BBr₃ to diffuse boron in each silicon wafer through the opening to provide a p type dopant diffusion region.

Then, each silicon wafer was immersed in an aqueous solution of fluoric acid to remove the masking paste therefrom entirely.

Then, a passivation film formed of silicon nitride film was provided by plasma CVD on each silicon wafer throughout the surface with the n type dopant diffusion region and the p type dopant diffusion region.

Then, each silicon wafer underwent texture etching at the surface opposite to that with the passivation film to have a textured structure. Note that texture etching was done with an etching liquid which was an aqueous solution of sodium hydroxide having a sodium hydroxide concentration of 3% by volume with isopropyl alcohol added thereto and had a temperature of 70°C to 80°C.

Each silicon wafer was then provided on the textured structure with anti-reflection film 9 formed of silicon nitride film by plasma CVD.

Then, each silicon wafer had the passivation film partially removed in strips to form contact holes to partially expose the n type dopant diffusion region and the p type dopant diffusion region, respectively.

Thereafter, a commercially available silver paste was applied to fill the contact holes, and then dried and heated and thus fired to provide silver electrodes in contact with the n type dopant diffusion region and the p type dopant diffusion region, respectively. The back electrode type solar cells of the Example of the invention, Comparative Example 1, and Comparative Example 2 were thus produced from the silicon wafers of the Example of the invention, Comparative Example 1, and Comparative Example 2, respectively.

Then, the back electrode type solar cells of the Example of the invention, Comparative Example 1, and Comparative Example 2 were exposed to pseudo solar light by a solar simulator to measure current-voltage (IV) characteristics to measure short circuit current density, open circuit voltage, F.F. (fill factor), and conversion efficiency. The result is shown in Table 1. Note that, in Table 1, the back electrode type solar cell of the Example of the invention has its short circuit current density, open circuit voltage, F.F., and conversion efficiency numerically represented as 100, and, with reference thereto, the back electrode type solar cells of Comparative Example 1 and Comparative Example 2 have their respective short circuit current densities, open circuit voltages, F.F.s, and conversion efficiencies numerically represented relatively.

**Table 1**

| | Short Circuit Current Density | Open Circuit Voltage | F.F. | Conversion Efficiency | Amount Etched on Either Side (µm) |
|---|---|---|---|---|---|
| Example | 100 | 100 | 100 | 100 | 13 |
| Comparative Example 1 | 99 | 101 | 100 | 100 | 30 |
| Comparative Example 2 | 95 | 90 | 90 | 77 | 13 |

As shown in Table 1, it has been confirmed that the back electrode type solar cell of the Example of the invention can constantly provide satisfactory characteristics equivalent to those of the back electrode type solar cell of Comparative Example 1 even when the former is formed using a silicon wafer etched by an amount approximately half that of the latter per surface on either side.

Furthermore, as shown in Table 1, it has been confirmed that the back electrode type solar cell of the Example of the invention can constantly provide better characteristics than the back electrode type solar cell of Comparative Example 2.

It is believed that this is because: the back electrode type solar cell of the Example of the invention can be produced with a silicon wafer having a smooth surface obtained with only a limited etched amount and provided with a silver electrode so that the surface of the silicon wafer and the silver electrode can contact each other over an increased area, which can contribute to reduced contact resistance between the surface of the silicon wafer and the silver electrode and reduced carrier recombination at an interface between the surface of the silicon wafer and the silver electrode; and the silicon wafer has a less uneven back surface and a masking paste can be printed thereon in a less irregular pattern and hence with improved precision.

### INDUSTRIAL APPLICABILITY

The present invention can be utilized for a silicon wafer, a semiconductor device, a method for producing the silicon wafer, and a method for producing the semiconductor device, and in particular, suitably utilized for a silicon wafer for a back electrode type solar cell and its production, and the back electrode type solar cell and its production.

### REFERENCE SIGNS LIST

1, 101: semiconductor substrate; 1a: slicing damage; 2, 102: masking paste; 3, 103: n type dopant diffusion region; 4, 104: n type dopant containing gas; 5, 105: p type dopant diffusion region; 6, 106: p type dopant containing gas; 7, 107: passivation film; 8, 108: textured structure; 9, 109: anti-reflection film; 10, 110: contact hole; 12, 112: electrode for n type; 13, 113: electrode for p type; 14, 15, 114, 115: opening; 50: semiconductor crystal ingot; 51, 52: guide roller; 53: wire saw; 53a: core wire; 53b: abrasive grain; 54, 55: arrow; 61: saw mark; 62, 63, 64: facet; 65: projection.

## Claims

1. A silicon wafer (1) obtained by etching by not less than 5 µm and not more than 25 µm per surface on either side a surface of crystalline silicon (11) obtained by cutting a silicon crystal ingot (50), the silicon wafer (1) having a surface with a facet (62) having a width of not less than 10 µm and not more than 150 µm.

2. The silicon wafer (1) according to claim 1, wherein said facet (62) has a depth of not less than 0.1 µm and not more than 10 µm.

3. A semiconductor device comprising:
a silicon wafer (1) according to claim 1 or 2; and
an electrode (12, 13) provided on said silicon wafer (1) at said surface having said facet (62).

4. A method for producing a silicon wafer (1), comprising the steps of:
forming crystalline silicon (11) by cutting a silicon crystal ingot (50); and
etching a surface of said crystalline silicon (11) with an aqueous solution of sodium hydroxide having a sodium hydroxide concentration of not less than 20% by mass and not more than 35% by mass,
in the step of etching, said crystalline silicon (11) being etched by an amount of not less than 5 µm and not more than 25 µm per surface on either side of said crystalline silicon (11).

5. The method for producing a silicon wafer (1) according to claim 4, wherein the step of forming said crystalline silicon (11) includes the step of cutting said silicon crystal ingot (50) with a wire saw (53).

6. A method for producing a semiconductor device, comprising the steps of:
forming crystalline silicon (11) by cutting a silicon crystal ingot (50);
etching a surface of said crystalline silicon (11) with an aqueous solution of sodium hydroxide having a sodium hydroxide concentration of not less than 20% by mass and not more than 35% by mass to provide a silicon wafer (1) having a surface with a facet (62) having a width of not less than 10 µm and not more than 150 µm; and
providing said silicon wafer (1) with an electrode (12, 13) at said surface having said facet (62),
in the step of etching to provide said silicon wafer (1), said crystalline silicon (11) being etched by an amount of not less than 5 µm and not more than 25 µm per surface on either side of said crystalline silicon (11).

7. The method for producing a semiconductor device according to claim 6, wherein the step of forming said crystalline silicon (11) includes the step of cutting said silicon crystal ingot (50) with a wire saw (53).

## Amended claims

### Amended claims under Art. 19.1 PCT

1. (Amended) A back electrode type solar cell comprising:
a silicon wafer (1) obtained by etching by not less than 5 µm and not more than 25 µm per surface on either side a surface of n type monocrystalline silicon (11) obtained by cutting an n type monocrystalline silicon ingot (50), said silicon wafer (1) having a surface with a facet (62) having a width of not less than 10 µm and not more than 150 µm;
an n type dopant diffusion region (3) and a p type dopant diffusion region (5) provided in said silicon wafer (1) at said surface having said facet (62);
an electrode for n type (12) provided on said n type dopant diffusion region (3); and
an electrode for p type (13) provided on said p type dopant diffusion region (5).

2. (Amended) The back electrode type solar cell according to claim 1, wherein said facet (62) has a depth of not less than 0.1 µm and not more than 10 µm.

3. (Cancelled)

4. (Amended) A method for producing a back electrode type solar cell, comprising the steps of:
forming n type monocrystalline silicon (11) by cutting an n type monocrystalline silicon ingot (50);
etching a surface of said n type monocrystalline silicon (11) with an aqueous solution of sodium hydroxide having a sodium hydroxide concentration of not less than 20% by mass and not more than 35% by mass to form a silicon wafer (1) having a surface with a facet (62) having a width of not less than 10 µm and not more than 150 µm;
providing an n type dopant diffusion region (3) in said silicon wafer (1) at said surface having said facet (62);
providing a p type dopant diffusion region (5) in said silicon wafer (1) at said surface having said facet (62);
providing an electrode for n type (12) on said n type dopant diffusion region (3); and
providing an electrode for p type (13) on said p type dopant diffusion region (5),
in the step of etching, said n type monocrystalline silicon (11) being etched by an amount of not less than 5 µm and not more than 25 µm per surface on either side of said n type monocrystalline silicon (11).

5. (Amended) The method for producing a back electrode type solar cell according to claim 4, wherein the step of forming said n type monocrystalline silicon (11) includes the step of cutting said n type monocrystalline silicon ingot (50) with a wire saw (53).

6. (Cancelled)

7. (Cancelled)
